# EUROPEAN PATENT SPECIFICATION

(11) **EP 3 085 069 B1**
(45) Date of publication and mention of the grant of the patent: **11.12.2019**
(21) Application number: 14784234.8
(22) Date of filing: 15.10.2014
(51) Int. Cl.: H04N 5/225, B60R 1/00, H05K 1/14

(54) **VEHICLE CAMERA CONSTRUCTED ACCORDING TO THE MODULAR CONCEPT AND MOTOR VEHICLE WITH SUCH A CAMERA**
NACH EINEM MODULAREN KONZEPT KONSTRUIERTE FAHRZEUGKAMERA UND KRAFTFAHRZEUG MIT SOLCH EINER KAMERA
CAMÉRA POUR VÉHICULE CONÇUE SELON UN CONCEPT MODULAIRE ET VÉHICULE À MOTEUR EN ÉTANT ÉQUIPÉ

(30) Priority: 21.12.2013 DE 102013021818
(43) Date of publication of application: 26.10.2016
(73) Proprietor: Connaught Electronics Ltd., Tuam, County Galway (IE)
(72) Inventor: WARD, Enda Peter, Corofin County Galway (IE); MCDAID, Patrick, Cahersiveen County Kerry (IE)
(74) Representative: Jauregui Urbahn, Kristian
(86) International application number: PCT/EP2014/072082
(87) International publication number: WO 2015/090670

(56) References cited:
- EP-A1- 2 393 277
- WO-A1-00/46984
- JP-A- 2005 079 931
- US-A1- 2006 038 108
- US-A1- 2010 118 145
- US-B1- 6 567 611

## Description

The invention relates to a vehicle camera for a motor vehicle, which includes an optical lens, an image sensor for detecting light through the lens and for providing image data, a digital image processing unit for pre-processing the image data as well as a communication interface for communication with a control device of the motor vehicle. The image sensor, the image processing unit and the communication interface are disposed in a camera housing of the vehicle camera. In addition, the invention relates to a motor vehicle with such a camera.

Camera systems for motor vehicles are already known from the prior art. As is known, several cameras can be employed in a motor vehicle, wherein it becomes increasingly common nowadays to use a camera assembly with at least two cameras for a camera system of a vehicle, which each capture an environmental region of the motor vehicle. For example, four cameras can be employed, which capture the entire environment around the motor vehicle. For example, an overall image presentation can be provided from the images of all of the cameras, such as for example the so-called "bird eye view". This image presentation represents a plan view of the motor vehicle as well as its environment from a bird's eye view and thus for example from a reference point of view directly above the motor vehicle. The provision of such an environmental representation from the images of several cameras is for example known from the document US 2011/0156887.

It is already prior art to employ multiple circuit boards one above the other in a vehicle camera. Therein, the use of multiple circuit boards has advantages with respect to the heat dissipation. Corresponding measures for dissipating heat from such a vehicle camera are for example described in the document WO 2013/020897 A1.

A vehicle camera with multiple circuit boards, on which electronic components are disposed, is additionally known from the documents JP 2001 275 022 A, US2010/0118145 A1, EP2393277 A1 as well as JP 2010 074 665 A. These cameras are particularly compactly constructed and therefore can also be placed in such positions in motor vehicles, in which relatively little installation space is available.

In addition, vehicle cameras belong to the prior art, which have an integrated image processing unit with a digital signal processor (in particular video processor). By means of this image processing unit, pre-processing of the image data provided by the image sensor can already be performed internally in the camera. Such a camera is for example known from the document CN 201716417.

Depending on the vehicle production series and the selected additional equipment features of the respective vehicle, different camera variants have to be produced, which provide different functionalities. For motor vehicles of the lower price segment, for example, cameras have to be provided, which are overall more inexpensive and are able to provide less functionalities compared to cameras for "high end" vehicles. Thus, overall, a plurality of camera variants has to be produced. This increases the production effort as well as the production cost.

It is an object of the invention to demonstrate a solution, how the production effort in producing a vehicle camera of the initially mentioned kind can be reduced compared to the prior art, and herein in particular the number of the required camera variants can be reduced.

According to the invention, this object is solved by a vehicle camera as well as by a motor vehicle having the features according to the respective independent claims. Advantageous implementations of the invention are the subject matter of the dependent claims, of the description and of the figures.

A vehicle camera according to the invention is conceived for installation in a motor vehicle, in particular a passenger car. The vehicle camera includes an optical lens as well as an image sensor formed for detecting light through the lens and for providing image data. The vehicle camera also includes a digital image processing unit formed for pre-processing the image data. In addition, the vehicle camera has a communication interface for communication with a control device of the motor vehicle external to camera. The image sensor, the image processing unit and the communication interface are disposed in a camera housing of the vehicle camera. In the camera housing, starting from the lens, a first, a second and a third circuit board (PCB) are consecutively disposed. The image sensor is disposed on the first circuit board, the image processing unit is disposed on the second circuit board and the communication interface is disposed on the third circuit board.

Accordingly, the vehicle camera according to the invention is modularly constructed such that the image sensor is located on the first circuit board disposed closest to the optical lens, and the image processing unit is disposed on the separate second circuit board, which is located between the first and the third circuit board, wherein the communication interface for communication with the control device of the motor vehicle is disposed on the third circuit board. Such a construction of the vehicle camera allows reduction of the camera variants compared to the prior art and thus overall reduces the production effort and the production cost. Namely, some variants can have identical image sensors and for example only differ in the image processing unit. In these variants, therefore, only the middle second circuit board with the associated image processing unit will be different. However, it can also be that some variants have identical image sensors as well as identical image processing units and only differ in the configuration of the communication interface. These variants also have the same first circuit board as well as the same second circuit board and only different third circuit boards with different variants of the communication interface have to be produced. A communication interface can for example be formed for wireless data communication, while another communication interface can serve for wired communication.

A further advantage of the vehicle camera according to the invention is in that it can be particularly compactly constructed due to the stacked arrangement of the circuit boards. Therein, in particular, dimensions of the vehicle camera of less than 28 mm x 24 mm x 24 mm can be achieved. Thus, the camera housing can be virtually cubically formed.

Preferably, the image sensor is a video image sensor being able to provide a sequence of images of an environmental region of the motor vehicle per second. Thus, the image sensor preferably provides video data, which can be processed by means of the image processing unit in real time. For example, the image sensor can be a CCD image sensor or a CMOS image sensor.

In an embodiment, it is provided that a non-volatile memory is also disposed on the first circuit board in addition to the image sensor, in which configuration data (boot data for booting) and/or image processing algorithms for the image sensor and/or for the image processing unit is stored. For example a flash memory, in particular an SPI (serial peripheral interface bus) flash memory, can be employed as the non-volatile memory. The arrangement of the non-volatile memory on the first circuit board has the advantage that this first circuit board including the image sensor and the non-volatile memory can be a cross-variant circuit board, which is employed in a plurality of different variants of the camera. Namely, each vehicle camera needs an image sensor as well as a non-volatile memory with configuration data and/or image processing algorithms.

In an embodiment, it can be provided that a RAM memory for storing current image data is also disposed on the second circuit board in addition to the image processing unit. This RAM memory can for example be formed as an mDDR (mobile DDR) memory, i.e. a particular implementation of DDR SDRAM (double data rate synchronous dynamic random access memory). Since different RAM memories in various implementations can also be employed for different camera variants, it is advantageous if the RAM memory is disposed on the second circuit board.

If both the image processing unit and the RAM memory are placed on the second circuit board, thus, corresponding measures are preferably to be taken, which ensure that these two components can be disposed on the second circuit board without influencing the above mentioned dimensions of the camera. It proves advantageous if the second circuit board is formed as an HDI (high density interconnect) circuit board and the image processing unit is disposed on a first side of the HDI circuit board, while the RAM memory is disposed on a second side of the HDI circuit board opposing the image processing unit. Therein, an HDI circuit board is a multilayer board, in which blind hole bores with a diameter of 50 µm to 100 µm are introduced into the exterior layers by means of laser or by plasma etching and terminate on the copper of the next or after next layer. After cleaning the remaining resin, these micro bore holes are in turn galvanically copper plated and thus electrically connected. By employment of such an HDI circuit board, the image processing unit on the one hand and the RAM memory on the other hand can be placed on the same circuit board without increasing the dimensions of the camera. Providing such an HDI circuit board thus overall allows particularly compact construction of the vehicle camera as well as additionally a particularly fast access to the RAM memory.

It has turned out advantageous if the first side of the HDI circuit board, on which the image processing unit is disposed, faces away from the image sensor. Thus, the RAM memory is disposed on one side of the HDI circuit board facing the image sensor. It has turned out that such an arrangement improves the heat dissipation and thus the thermal characteristics of the vehicle camera.

Alternatively to an HDI circuit board, it can also be provided that the image processing unit and the RAM memory are positioned in a so-called "package on package" arrangement on the second circuit board. In this embodiment, the RAM memory can be disposed stacked on the image processing unit as a separate BGA (ball grid array) component. This too results in compact configuration of the vehicle camera.

The use of an image processing unit with an embedded RAM memory (stack die packaging) constitutes a further alternative.

In an embodiment, it is provided that the image processing unit includes a digital signal processor for processing the image data and additionally a controller (CPU), which is adapted to switch the digital signal processor and/or the image sensor into an energy saving mode. In this manner, electrical energy can be saved. The energy saving mode can for example be activated if the temperature within the vehicle camera exceeds a predetermined limit value. However, the energy saving mode can also constitute a standby mode of the vehicle camera, in which the image sensor and the digital signal processor are disconnected from the energy source and only the controller is operable. If a control signal for activating the vehicle camera is then received, thus, the startup of the vehicle camera can be particularly fast performed without complete booting of the image processing unit being required.

Overall, the image processing unit can include the following components:
- the mentioned digital signal processor (DSP/SIMD) formed for processing the image data; and/or
- the mentioned controller (for example a RISC CPU), which controls the image processing chain including the image sensor and the digital signal processor and is able to switch the vehicle camera into the mentioned energy saving mode; and/or
- an interface (in particular I2C interface) for connecting other components, such as for example an energy supply component and/or a register of the image sensor; and/or
- an interface (in particular a dual SPI interface) for booting from the mentioned flash memory (in particular SPI flash) as well as for communication with an external microcontroller; and/or
- a video interface for outputting the image data, in particular according to the RGB standard and/or the BT656 standard; and/or
- a SDIO interface and/or an USB interface for communication with the communication interface on the third circuit board.

The third circuit board including the communication interface can be formed specific to variant and thus depending on the requirements of the vehicle manufacturers. In an embodiment, it is provided that the communication interface includes a communication module formed for wirelessly transmitting the image data to the control device of the motor vehicle and/or for wirelessly receiving vehicle data from the control device. Therein, for example, a WiFi module (also known as a WLAN module) can be employed as the communication module, in which the data is transmitted according to the WiFi communication standard. Such a communication module has the advantage that the number of the required wires or lines can be reduced to a minimum and optionally even the employment of wired connections in the vehicle camera can be unnecessary.

It is provided that a non-volatile additional memory and/or an interface for a mobile storage medium (a so-called reader for a mobile storage medium) is disposed on the third circuit board in addition to the communication interface. Providing such an additional memory and/or such an interface for a mobile storage medium has the advantage that the image data can also be stored for a subsequent and later post-processing. Such storage of image data also proves particularly advantageous in case of a collision since here the collision can be pictorially documented. If an interface for a mobile storage medium is used, thus, for example, a reader for an SD card can be employed. Additionally or alternatively, an interface for an USB memory can also be employed.

The image processing unit is adapted to receive a trigger signal and to store the current image data in the additional memory and/or in the external mobile storage medium via the interface after receiving the trigger signal. Thus, the image data is only stored after receiving the trigger signal by the image processing unit, for example after detection of a collision situation.

It has proven advantageous if the vehicle camera includes a sensor device with at least one collision sensor, wherein the sensor device is adapted to detect a collision of the motor vehicle based on sensor data of the at least one collision sensor and to output the trigger signal to the image processing device after detection of the collision. The detection of the collision thus is effected internally in the vehicle camera such that the image data can be reliably stored in case of a collision and additionally situations are prevented, in which a trigger signal is not communicated in case of collision for instance since a control line is disconnected due to the collision.

Additionally or alternatively, the trigger signal can also be communicated from outside of the vehicle camera to the image processing unit, for example via a CAN bus and/or via the WiFi communication and/or via the above mentioned USB interface.

The use of the above mentioned RAM memory, in particular an SDRAM memory, allows storage of a plurality of video images for subsequently processing in inexpensive manner and also can be used as a storage space for codes or data in multitasking operating systems. It also constitutes a storage medium, which can be employed to install a storage system in a more complex operating system (e.g. Linux); the use of Linux results in reduced software development time, in facilitated integration of external peripheral drivers and in lower marketing time for new developments.

In particular, the following advantages result from a combination of the digital signal processor (e.g. video processor) and the RAM memory:
- processing of operations over several frames;
- autonomous calibration of variations in the position of the camera in the installation and during lifetime;
- highly developed graphics - e.g. overlays can be dynamically generated in real time depending on the current steering angle;
- dynamic control of the frame rate;
- configurable support of various input/output video resolutions;
- support of complex S/W OS (Linux) and network stack implementations and algorithms (e.g. WiFi interface with support of compression and network streaming (e.g. RTSP, Bonjour) and moving processing-intensive tasks to the processing in a "cloud" server).

A motor vehicle according to the invention, in particular a passenger car, includes a vehicle camera according to the invention.

Further features of the invention are apparent from the claims, the figures and the description of figures. All of the features and feature combinations mentioned above in the description as well as the features and feature combinations mentioned below in the description of figures and/or shown in the figures alone are usable not only in the respectively specified combination, but also in other combinations or else alone.

Now, the invention is explained in more detail based on individual preferred embodiments as well as with reference to the attached drawings.

There show:
- Fig. 1: in schematic exploded view a vehicle camera according to an embodiment of the invention;
- Fig. 2: a block diagram of a vehicle camera according to a first variant;
- Fig. 3: a block diagram of a vehicle camera according to a second variant; and
- Fig. 4: in schematic illustration an HDI circuit board with an image processing unit and a RAM memory.

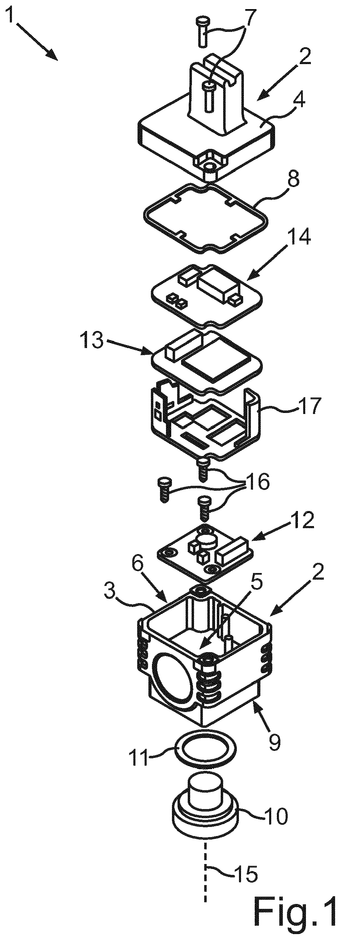

A vehicle camera 1 shown in schematic illustration in Fig. 1 is conceived for employment in a passenger car and preferably has overall dimensions, which are smaller than 28 mm x 24 mm x 24 mm. The vehicle camera 1 includes a camera housing 2, which is composed of a base body 3 and a lid 4 in the embodiment. An interior space 5 is formed in the base body 3, in which the electronic components of the vehicle camera 1 can be accommodated. The assembly opening is then closed by the lid 4 on a rear side 6, which is connected to the base body 3 via screws 7. A seal 8 can be inserted in between.

On a front side 9 of the camera housing 2 opposing the rear side 6, a lens 10 is attached above a sealing ring 11.

In the internal space 5, three circuit boards are overall attached in the vehicle camera 1, namely a first circuit board 12, a second circuit board 13 as well as a third circuit board 14. The circuit boards 12, 13, 14 are disposed lying one above the other. Starting from the lens 10, first, the first circuit board 12, then the second circuit board 13 and then the third circuit board 14 are assembled such that the circuit boards 12, 13, 14 are disposed consecutively according to the following order starting from the lens 10: the first circuit board 12, the second circuit board 13 and the third circuit board 14. Then, the circuit boards 12, 13, 14 are parallel to each other and perpendicular to the optical axis 15 of the vehicle camera 1. The circuit boards 12, 13, 14 are attached in a distance to each other with the aid of screws 16 as well as by means of a rack 17.

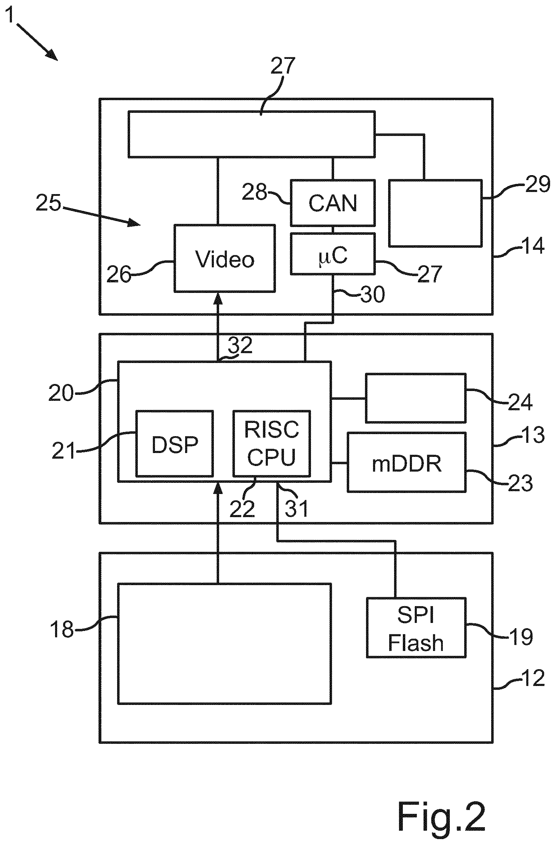

A first variant of the vehicle camera 1 is illustrated in more detail in Fig. 2. On the first circuit board 12, here, an image sensor 18 as well as a non-volatile flash memory 19 are disposed, which is in particular formed as an SPI flash.

On the second circuit board 13, an image processing unit 20 is disposed. It includes a digital signal processor 21 (DSP) as well as a controller 22. On the second circuit board 13, in addition, a RAM memory 23 for the image processing unit 20 as well as an energy supply unit 24 for providing electrical energy are disposed.

On the third circuit board 14, in turn, a communication interface 25 for communication with a vehicle-side control device is disposed.

The image sensor 18 serves for providing image data being video data and communicated to the image processing unit 20. In the flash memory 19, configuration data or so-called boot data for the image sensor 18 and/or for the image processing unit 20 is stored. Additionally or alternatively, image processing algorithms can also be stored in the flash memory 19, to which the image processing unit 20 and/or the image sensor 18 can access.

The digital signal processor 21 serves for pre-processing the video data. Therein, different image processing algorithms can be executed. Therein, for example, a gamma correction of the images and/or a so-called "black level" correction of the images and/or a white balance can be performed. Therein, the current image data can be stored in the RAM memory 23, which is formed as mDDR in the embodiment.

The processed image data is then output to the control device of the motor vehicle via a video interface 26 of the communication interface 25 as well as via ports 27. The image processing unit 20 is additionally connected to the CAN bus of the motor vehicle via a microcontroller 27 as well as a CAN interface 28 of the communication interface 25 as well as via ports 27. The energy required for operation of the camera 1 is provided via an energy interface 29 as well as corresponding ports 27.

The microcontroller 27 is coupled to the image processing unit via an SPI bus 30.

The controller 22 can switch the signal processor 21 and/or the image sensor 18 into an energy saving mode. This switching is effected depending on signals received by the controller 22 from outside of the camera 1. Overall, the vehicle camera 1 can have a standby mode, in which the signal processor 21 and the image mode 18 are deactivated and only the controller 22 can receive the control signals and reactivate the camera 1 after receiving a signal. Thus, a relatively fast startup of the camera 1 is possible without complete booting of the image processing unit 20 being required. The energy saving mode can also be activated if the temperature within the camera 1 exceeds a preset limit value.

The boot data can be read out from the flash memory 19 by the controller 22 via an SPI interface 31.

The video data is output by the image processing unit 20 via a video interface 32, in particular according to the RGB standard and/or the BT656 standard.

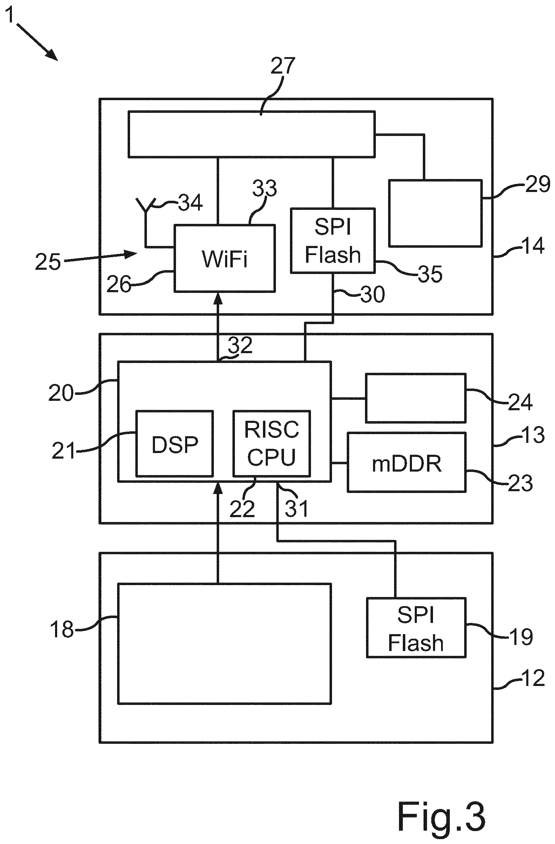

A second variant of the vehicle camera 1 is illustrated in Fig. 3. This variant differs from that according to Fig. 2 in that the communication interface 25 includes a communication module 33 with an associated antenna 34. Thus, the communication with the vehicle-side control device is here effected wirelessly by means of the communication module 33, for example according to the WiFi standard. Here, the video data is wirelessly transmitted and/or vehicle data is wirelessly received. In addition, an additional memory 35 is disposed on the third circuit board 14. Additionally or alternatively to this additional memory 35, an interface for a mobile data carrier can also be employed.

Such an additional memory 35 and/or such an interface for a mobile storage medium can also be employed in the variant according to Fig. 2.

In the additional memory 35 and/or the mobile data carrier, the image data can be stored. This storage is effected by the image processing unit 20 in particular due to a trigger signal. This trigger signal can be generated internally in the vehicle camera 1 and/or received from outside of the vehicle camera 1. If the trigger signal is internally generated, thus, it is preferably provided that the vehicle camera 1 includes a sensor device (not shown) with a collision sensor, for example an acceleration sensor. This sensor device then generates the trigger signal if a collision is detected based on the sensor data of the collision sensor.

A trigger signal can also originate from outside of the camera 1 and be communicated to the image processing unit 20 for example via the communication module 33 and/or via a separate USB interface and/or another interface.

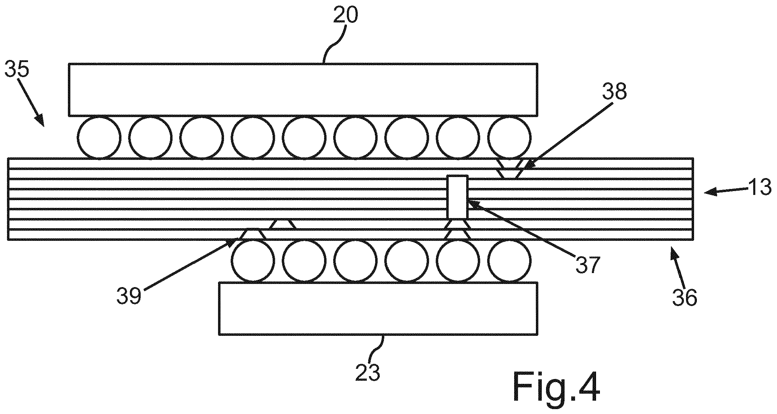

Since both the image processing unit 20 and the RAM memory are disposed on the second circuit board 13, basically, measures have to be taken, which ensure that these two components can be accommodated on the second circuit board 13 without exceeding the above mentioned dimensions of the camera 1. Therefore, in the embodiment, it is provided that the second circuit board 13 is formed as a so-called HDI circuit board as it is schematically illustrated in Fig. 4. Therein, the image processing unit 20 is disposed on a first side 35 of the circuit board 13; the RAM memory 23 is disposed on a second side 36 of the circuit board 13. Therein, the second side 36 faces the image sensor 18, while the first side 35 faces away from the image sensor 18 and thus faces the third circuit board 14. As is apparent from Fig. 4, such an HDI circuit board 13 can have so-called buried vias 37, stacked microvias 38 as well as staggered microvias 39. Therein, the use of an HDI circuit board additionally also allows a particularly fast access to the RAM memory 23.

## Claims

1. Vehicle camera (1) for a motor vehicle comprising an optical lens (10), comprising an image sensor (18) for detecting light through the lens (10) and for providing image data, comprising a digital image processing unit (20) for pre-processing the image data, and including a communication interface (25) for communication with a control device of the motor vehicle, wherein the image sensor (18), the image processing unit (20) and the communication interface (25) are disposed in a camera housing (2) of the vehicle camera (1),
**characterized in that**
a first, a second and a third circuit board (12, 13, 14) are consecutively disposed in the camera housing (2) starting from the lens (10), wherein the image sensor (18) is disposed on the first circuit board (12), the image processing unit (20) is disposed on the second circuit board (13) and the communication interface (25) is disposed on the third circuit board (14) and a non-volatile memory (35) is disposed on the third circuit board (14) in addition to the communication interface (25) and the image processing unit (20) is adapted to receive a trigger signal and to store the current image data in the non-volatile memory (35), wherein storing of the current image data is effected due to the trigger signal, J 2. and the vehicle camera (1) includes a sensor device with at least one collision sensor, wherein the sensor device is adapted to detect a collision of the motor vehicle based on sensor data of the at least one collision sensor and to output the trigger signal to the image processing unit (20) upon detecting the collision.

2. Vehicle camera (1) according to claim 1,
**characterized in that** a further non-volatile memory (19), in particular a flash memory, is disposed on the first circuit board (12) in addition to the image sensor (18), in which configuration data and/or image processing algorithms for the image sensor (18) and/or for the image processing unit (20) are stored.

3. Vehicle camera (1) according to claim 1 or 2,
**characterized in that**
on the second circuit board (13) a RAM memory (23) for storing current image data is disposed in addition to the image processing unit (20).

4. Vehicle camera (1) according to claim 3,
**characterized in that**
the second circuit board (13) is formed as an HDI circuit board, wherein the image processing unit (20) is disposed on a first side (35) of the HDI circuit board and the RAM memory (23) is disposed on a second side (36) of the HDI circuit board opposing the image processing unit (20).

5. Vehicle camera (1) according to claim 4,
**characterized in that**
the first side (35) of the HDI circuit board faces away from the image sensor (18).

6. Vehicle camera (1) according to any one of the preceding claims,
**characterized in that**
the image processing unit (20) includes a digital signal processor (21) for processing the image data and a controller (22) adapted to switch the digital signal processor (21) and/or the image sensor (18) into an energy saving mode.

7. Vehicle camera (1) according to any one of the preceding claims,
**characterized in that**
the communication interface (25) includes a communication module (33), which is formed for wirelessly transmitting the image data to the control device and/or for wirelessly receiving vehicle data from the control device.

8. Vehicle camera (1) according to any one of the preceding claims,
**characterized in that**
an interface for a mobile storage medium is disposed on the third circuit board (14) in addition to the communication interface (25).

9. Vehicle camera (1) according to claim 8,
**characterized in that**
the image processing unit (20) is adapted to receive a trigger signal and to store the current image data in the mobile storage medium via the interface after receiving the trigger signal.

10. Motor vehicle with a vehicle camera (1) according to any one of the preceding claims.

## Patentansprüche

1. Fahrzeugkamera (1) für ein Kraftfahrzeug, umfassend eine optische Linse (10), umfassend einen Bildsensor (18) zum Detektieren von Licht durch die Linse (10) und zum Bereitstellen von Bilddaten, umfassend eine digitale Bildverarbeitungseinheit (20) zur Vorverarbeitung der Bilddaten und umfassend eine Kommunikationsschnittstelle (25) zur Kommunikation mit einer Steuerungsvorrichtung des Kraftfahrzeugs, wobei der Bildsensor (18), die Bildverarbeitungseinheit (20) und die Kommunikationsschnittstelle (25) in einem Kameragehäuse (2) der Fahrzeugkamera (1) angeordnet sind,
**dadurch gekennzeichnet, dass**
eine erste, eine zweite und eine dritte Leiterplatte (12, 13, 14), angefangen bei der Linse (10), nacheinander in dem Kameragehäuse (2) angeordnet sind, wobei der Bildsensor (18) auf der ersten Schaltungsplatine (12) angeordnet ist, die Bildverarbeitungseinheit (20) auf der zweiten Leiterplatte (13) angeordnet ist und die Kommunikationsschnittstelle (25) auf der dritten Leiterplatte (14) angeordnet ist und ein nicht flüchtiger Speicher (35) zusätzlich zu der Kommunikationsschnittstelle (25) auf der dritten Leiterplatte (14) angeordnet ist und die Bildverarbeitungseinheit (20) eingerichtet ist, um ein Auslösesignal zu empfangen und die aktuellen Bilddaten in dem nicht flüchtigen Speicher (35) zu speichern, wobei Speichern der aktuellen Bilddaten aufgrund des Auslösesignals bewirkt wird, und die Fahrzeugkamera (1) eine Sensorvorrichtung mit mindestens einem Kollisionssensor umfasst, wobei die Sensorvorrichtung eingerichtet ist, um eine Kollision des Kraftfahrzeugs auf der Grundlage von Sensordaten des mindestens einen Kollisionssensors zu detektieren und das Auslösesignal bei Detektieren der Kollision an die Bildverarbeitungseinheit (20) auszugeben.

2. Fahrzeugkamera (1) nach Anspruch 1,
**dadurch gekennzeichnet, dass**
ein weiterer nicht flüchtiger Speicher (19), insbesondere ein Flash-Speicher, auf der ersten Schaltungsplatine (12) zusätzlich zu dem Bildsensor (18) angeordnet ist, in dem Konfigurationsdaten und/oder Bildverarbeitungsalgorithmen für den Bildsensor (18) und/oder für die Bildverarbeitungseinheit (20) gespeichert sind.

3. Fahrzeugkamera (1) nach Anspruch 1 oder 2,
**dadurch gekennzeichnet, dass**
auf der zweiten Leiterplatte (13) zusätzlich zu der Bildverarbeitungseinheit (20) ein RAM-Speicher (23) zum Speichern aktueller Bilddaten angeordnet ist.

4. Fahrzeugkamera (1) nach Anspruch 3,
**dadurch gekennzeichnet, dass**
die zweite Leiterplatte (13) als eine HDI-Leiterplatte ausgebildet ist, wobei die Bildverarbeitungseinheit (20) auf einer ersten Seite (35) der HDI-Leiterplatte angeordnet ist und der RAM-Speicher (23) auf einer zweiten Seite (36) der HDI-Leiterplatte der Bildverarbeitungseinheit (20) gegenüberliegend angeordnet ist.

5. Fahrzeugkamera (1) nach Anspruch 4,
**dadurch gekennzeichnet, dass**
die erste Seite (35) der HDI-Leiterplatte von dem Bildsensor (18) weg zeigt.

6. Fahrzeugkamera (1) nach einem der vorhergehenden Ansprüche,
**dadurch gekennzeichnet, dass**
die Bildverarbeitungseinheit (20) einen digitalen Signalprozessor (21) zum Verarbeiten der Bilddaten und eine Steuervorrichtung (22) umfasst, die eingerichtet ist, um den digitalen Signalprozessor (21) und/oder den Bildsensor (18) in eine Stromsparbetriebsart zu schalten.

7. Fahrzeugkamera (1) nach einem der vorhergehenden Ansprüche,
**dadurch gekennzeichnet, dass**
die Kommunikationsschnittstelle (25) ein Kommunikationsmodul (33) umfasst, das zum drahtlosen Senden der Bilddaten an die Steuerungsvorrichtung und/oder zum drahtlosen Empfangen von Fahrzeugdaten aus der Steuerungsvorrichtung ausgebildet ist.

8. Fahrzeugkamera (1) nach einem der vorhergehenden Ansprüche,
**dadurch gekennzeichnet, dass**
eine Schnittstelle für ein mobiles Speichermedium zusätzlich zu der Kommunikationsschnittstelle (25) auf der dritten Leiterplatte (14) angeordnet ist.

9. Fahrzeugkamera (1) nach Anspruch 8,
**dadurch gekennzeichnet, dass**
die Bildverarbeitungseinheit (20) eingerichtet ist, um ein Auslösesignal zu empfangen und nach Empfangen des Auslösesignals die aktuellen Bilddaten über die Schnittstelle in dem mobilen Speichermedium zu speichern.

10. Kraftfahrzeug mit einer Fahrzeugkamera (1) nach einem der vorhergehenden Ansprüche.

## Revendications

1. Caméra (1) pour véhicule destinée à un véhicule à moteur, comportant un objectif optique (10), comportant un capteur (18) d'image servant à détecter une lumière traversant l'objectif (10) et à fournir des données d'image, comportant une unité (20) de traitement d'image numérique servant à prétraiter les données d'image, et comprenant une interface (25) de communication servant à la communication avec un dispositif de commande du véhicule à moteur, le capteur (18) d'image, l'unité (20) de traitement d'image et l'interface (25) de communication étant disposés dans un boîtier (2) de caméra de la caméra (1) pour véhicule,
**caractérisée en ce que**
une première, une deuxième et une troisième carte (12, 13, 14) à circuits sont disposées consécutivement dans le boîtier (2) de caméra en partant de l'objectif (10), le capteur (18) d'image étant disposé sur la première carte (12) à circuits, l'unité (20) de traitement d'image étant disposée sur la deuxième carte à circuits (13) et l'interface (25) de communication étant disposée sur la troisième carte (14) à circuits et
une mémoire non volatile (35) étant disposée sur la troisième carte (14) à circuits en plus de l'interface (25) de communication et
l'unité (20) de traitement d'image étant prévue pour recevoir un signal de déclenchement et pour stocker les données d'image actuelles dans la mémoire non volatile (35), le stockage des données d'image actuelles étant effectué en raison du signal de déclenchement, et
la caméra (1) pour véhicule comprenant un dispositif de capteur doté d'au moins un capteur de collision, le dispositif de capteur étant prévu pour détecter une collision du véhicule à moteur d'après des données de capteur du ou des capteurs de collision et pour délivrer le signal de déclenchement à l'unité (20) de traitement d'image suite à la détection de la collision.

2. Caméra (1) pour véhicule selon la revendication 1,
**caractérisée en ce que**
une mémoire non volatile supplémentaire (19), en particulier une mémoire Flash, est disposée sur la première carte (12) à circuits en plus du capteur (18) d'image, dans laquelle sont stockés des données de configuration et/ou des algorithmes de traitement d'image destinés au capteur (18) d'image et/ou à l'unité (20) de traitement d'image.

3. Caméra (1) pour véhicule selon la revendication 1 ou 2,
**caractérisée en ce que**
sur la deuxième carte à circuits (13) est disposée une mémoire RAM (23) servant à stocker des données d'image actuelles, en plus de l'unité (20) de traitement d'image.

4. Caméra (1) pour véhicule selon la revendication 3,
**caractérisée en ce que**
la deuxième carte à circuits (13) est formée comme une carte à circuits HDI, l'unité (20) de traitement d'image étant disposée sur un premier côté (35) de la carte à circuits HDI et la mémoire RAM (23) étant disposée sur un deuxième côté (36) de la carte à circuits HDI opposé à l'unité (20) de traitement d'image.

5. Caméra (1) pour véhicule selon la revendication 4,
**caractérisée en ce que**
le premier côté (35) de la carte à circuits HDI est orienté à l'opposé du capteur (18) d'image.

6. Caméra (1) pour véhicule selon l'une quelconque des revendications précédentes,
**caractérisée en ce que**
l'unité (20) de traitement d'image comprend un processeur (21) de signaux numériques servant à traiter les données d'image et un moyen (22) de commande prévu pour faire passer le processeur (21) de signaux numériques et/ou le capteur (18) d'image dans un mode d'économie d'énergie.

7. Caméra (1) pour véhicule selon l'une quelconque des revendications précédentes,
**caractérisée en ce que**
l'interface (25) de communication comprend un module (33) de communication, qui est formé pour émettre sans fil les données d'image vers le dispositif de commande et/ou pour recevoir sans fil des données de véhicule en provenance du dispositif de commande.

8. Caméra (1) pour véhicule selon l'une quelconque des revendications précédentes,
**caractérisée en ce que**
une interface destinée à un support de stockage mobile est disposée sur la troisième carte (14) à circuits en plus de l'interface (25) de communication.

9. Caméra (1) pour véhicule selon la revendication 8,
**caractérisée en ce que**
l'unité (20) de traitement d'image est prévue pour recevoir un signal de déclenchement et pour stocker les données d'image actuelles dans le support de stockage mobile via l'interface après avoir reçu le signal de déclenchement.

10. Véhicule à moteur muni d'une caméra (1) pour véhicule selon l'une quelconque des revendications précédentes.
